# EUROPEAN PATENT APPLICATION

(11) **EP 4 832 510 A1**
(43) Date of publication of application: **28.10.2026**
(21) Application number: 26174169.8
(22) Date of filing: 23.04.2026
(51) Int. Cl.: H04R 19/00, G10K 15/04, H04R 17/10, H04R 19/02

(54) **SEMICONDUCTOR DEVICE AND MANUFACTURING METHOD OF SEMICONDUCTOR DEVICE**

(30) Priority: 27.04.2025 US 202563795613 P; 22.04.2026 US 202619655675
(71) Applicant: xMEMS Labs, Inc., Santa Clara, CA 95051 (US)
(72) Inventor: Ng, Eldwin Jiaqiang, Sunnyvale, 94087 (US); Chen, Lei, Hayward, 94542 (US); Liang, Jemm Yue, Sunnyvale, 94086 (US)
(74) Representative: Straus, Alexander

(57) **Abstract**

The semiconductor device (SD1) includes a film structure (FS) and a protruding structure (PS). The protruding structure (PS) is formed on a free edge (FE) of a portion of the film structure (FS), and configured to enhance a thickness of the free edge (FE) in a cross sectional view. A manufacturing method of this semiconductor device (SD1) is also provided.

## Description

### Field of the Invention

The present invention relates to a semiconductor device and a manufacturing method of a semiconductor device, wherein the semiconductor device reduces unwanted backflow during operation.

### Background of the Invention

Nowadays, semiconductor devices can be widely used in various electronic devices, so as to achieve some functions. For instance, some semiconductor devices (e.g., acoustic devices, such as speakers and air-pulse generating devices) are capable of producing the sound, some semiconductor devices (e.g., air-pulse generating devices and airflow generating devices) are capable of producing the airflow, and some semiconductor devices (e.g., venting devices) are capable of controlling whether their valves are open or closed.

However, unwanted backflow or leakage would be caused during the operation of the above semiconductor devices, such that adverse effect(s) would be applied on the aforementioned functions. Thus, it is necessary to improve these semiconductor devices, so as to reduce unwanted backflow or leakage during the operation.

### Summary of the Invention

This in mind, the present invention aims at providing a semiconductor device having a protruding structure disposed adjacent to a free edge of a film structure, so as to reduce unwanted backflow during operation. Furthermore, the present invention further provides a manufacturing method of this semiconductor device.

This is achieved by a semiconductor device and a manufacturing method of this semiconductor device according to the independent claims. The dependent claims pertain to corresponding further developments and improvements.

As will be seen more clearly from the detailed description following below, the claimed semiconductor device includes a film structure and a protruding structure. The protruding structure is formed on a free edge of a portion of the film structure, and configured to enhance a thickness of the free edge in a cross sectional view.

As will be seen more clearly from the detailed description following below, the claimed manufacturing method of a semiconductor device is provided. The manufacturing method includes following steps: providing a wafer; forming a slit on the wafer, wherein the slit defines a free edge of a film structure; and forming a protruding structure on the free edge of the film structure, wherein the protruding structure is configured to enhance a thickness of the free edge in a cross sectional view.

### Brief Description of the Drawings

In the following, the disclosure is further illustrated by way of example, taking reference to the accompanying drawings. Thereof
FIG. 1 is a cross sectional view schematic diagram illustrating a semiconductor device according to a first embodiment of the present invention,
FIG. 2 is a cross sectional view schematic diagram illustrating three states of the semiconductor device according to the first embodiment of the present invention,
FIG. 3 and FIG. 4 are cross sectional view schematic diagrams illustrating an example movement of the semiconductor device according to the first embodiment of the present invention,
FIG. 5 is a cross sectional view schematic diagram illustrating another example movement of the semiconductor device according to the first embodiment of the present invention,
FIG. 6 to FIG. 11 are cross sectional view schematic diagrams illustrating structures at different stages of a manufacturing method of the semiconductor device according to the first embodiment of the present invention,
FIG. 12 to FIG. 17 are cross sectional view schematic diagrams illustrating structures at different stages of a manufacturing method of a semiconductor device according to a second embodiment of the present invention,
FIG. 18 is a cross sectional view schematic diagram illustrating a semiconductor device according to a third embodiment of the present invention, and
FIG. 19 is a cross sectional view schematic diagram illustrating a semiconductor device according to a fourth embodiment of the present invention.

### Detailed Description

To provide a better understanding of the present invention to those skilled in the art, preferred embodiments and typical material or range parameters for key components will be detailed in the follow description. These preferred embodiments of the present invention are illustrated in the accompanying drawings with numbered elements to elaborate on the contents and effects to be achieved. It should be noted that the drawings are simplified schematics, and the material and parameter ranges of key components are illustrative based on the present day technology, and therefore show only the components and combinations associated with the present invention, so as to provide a clearer description for the basic structure, implementing or operation method of the present invention. The components would be more complex in reality and the ranges of parameters or material used may evolve as technology progresses in the future. In addition, for ease of explanation, the components shown in the drawings may not represent their actual number, shape, and dimensions; details may be adjusted according to design requirements.

In the description and following claims, when a component or layer is referred to as being "connected to" another component or layer, it can be directly connected to this another component or layer, or intervening components or layers may be presented. In contrast, when a component is referred to as being "directly connected to" another component or layer, there are no intervening components or layers presented.

In the description and following claims, when "a A1 component is formed by/of B1", B1 exist in the formation of A1 component or B1 is used in the formation of A1 component, and the existence and use of one or a plurality of other features, areas, steps, operations and/or components are not excluded in the formation of A1 component.

In the description and following claims, the term "substantially" generally means a small deviation may exist or not exist. For instance, the terms "substantially parallel" and "substantially along" means that an angle between two components may be less than or equal to a certain degree threshold, e.g., 10 degrees, 5 degrees, 3 degrees or 1 degree. For instance, the term "substantially aligned" means that a deviation between two components may be less than or equal to a certain difference threshold, e.g., 2 µm or 1 µm. For instance, the term "substantially the same" means that a deviation is within, e.g., 10% of a given value or range, or mean within 5%, 3%, 2%, 1%, or 0.5% of a given value or range.

In the description and following claims, the term "horizontal direction" generally means a direction parallel to a horizontal plane, the term "horizontal plane" generally means a plane parallel to directions X and Y in the drawings (i.e., the directions X and Y may be considered as the horizontal directions), the term "vertical direction" and the term "top-view direction" generally mean a direction parallel to a direction Z and perpendicular to the horizontal direction in the drawings, and the directions X, Y and Z are perpendicular to each other. In the description and following claims, the term "top view" generally means a viewing result viewing along the vertical direction. In the description and following claims, the term "cross-sectional view" generally means a structure cut along the vertical direction is viewed along the horizontal direction.

It should be noted that the technical features in different embodiments described in the following can be replaced, recombined, or mixed with one another to constitute another embodiment without departing from the spirit of the present invention. That is, the technical features described in the embodiments may be mixed or combined in various ways as long as there are no conflicts between them.

The present invention provides a semiconductor device, wherein the semiconductor device is formed by a semiconductor manufacturing process, and configured to achieve at least one function. For example, the semiconductor device may be a micro electro mechanical system (MEMS) chip including a MEMS structure, but not limited thereto.

For example, the semiconductor device (e.g., an acoustic device, such as a speaker and an air-pulse generating (APG) device) may be capable of producing the acoustic wave, but not limited thereto. For example, the speaker may produce the acoustic wave with a frequency lower than or equal to the maximum human audible frequency (e.g., 16 kHz, 20 kHz or 22 kHz) for producing the sound, or produce the acoustic wave with a frequency higher than the maximum human audible frequency for producing the ultrasonic sound. For example, the APG device may produce a plurality of air pulses, and the acoustic wave may be produced by the contours (or envelope) of the air pulses, wherein the air pulses may be produced at an ultrasonic pulse rate.

For example, the semiconductor device (e.g., an APG device and an airflow generating device) may be capable of producing the airflow for causing the air movement, but not limited thereto. For example, the airflow produced by the airflow generating device and the airflow formed of the air pulses produced by the APG device may be configured to dissipate the heat, sample the air or pump the air. The air pulses produced by the APG device may be produced at any suitable pulse rate. For example, the air pulses may be produced at the ultrasonic pulse rate, such that users cannot hear the operation of the APG device, but not limited thereto.

For example, the semiconductor device (e.g., a venting device) may be capable of controlling whether its valve is open or closed, but not limited thereto. For example, the venting device may be configured to suppress an occlusion effect during the operation of the acoustic device (e.g., an in-ear earbud, an on-ear earphone or an over-ear earphone, etc.), wherein the occlusion effect is due to the sealed volume of ear canal causing loud perceived sound pressure by the user (i.e., the listener). Because of the existence of the venting device, the volume of ear canal is not sealed when the valve of the venting device is opened, such that the occlusion effect may be suppressed, thereby enhancing the performance of the acoustic device and the experience of the user using the acoustic device.

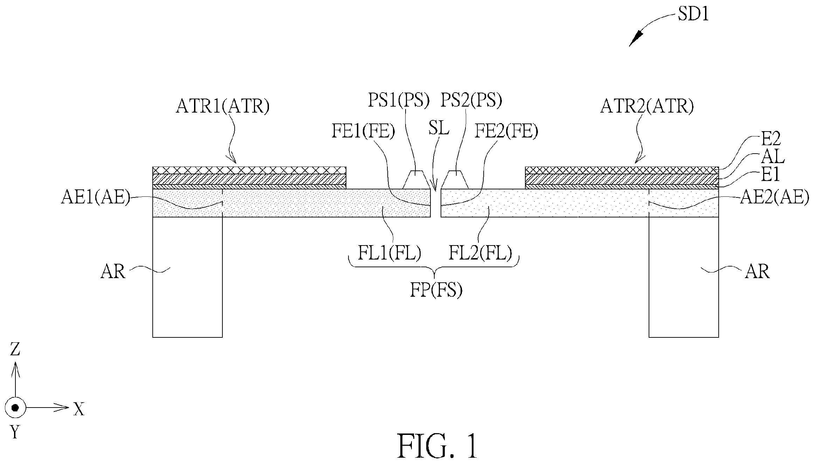

Referring to FIG. 1, FIG. 1 is a cross sectional view schematic diagram illustrating a semiconductor device according to a first embodiment of the present invention. As shown in FIG. 1, the semiconductor device SD1 may include at least one anchor structure AR and at least one film structure FS anchored by/on the anchor structure AR. The film structure FS and the anchor structure AR may include any suitable material(s). In some embodiments, the film structure FS and the anchor structure AR may individually include silicon (e.g., single crystalline silicon or poly-crystalline silicon), silicon compound (e.g., silicon carbide, silicon oxide), germanium, germanium compound, gallium, gallium compound (e.g., gallium nitride or gallium arsenide), other suitable material or a combination thereof, but not limited thereto. In some embodiments, the film structure FS and the anchor structure AR may have the same material.

In the operation of the semiconductor device SD1, the film structure FS may be actuated to have a movement parallel to the direction Z, and the anchor structure AR may be immobilized. Namely, the anchor structure AR may be a fixed end (or fixed edge) respecting the film structure FS during the operation of the semiconductor device SD1.

As shown in FIG. 1, the film structure FS of the semiconductor device SD1 includes at least one slit SL, and the film structure FS is divided into a plurality of flaps FL by the slit(s) SL (i.e., the slit SL penetrates the film structure FS). In the present invention, the slit SL may be a straight slit, a curved slit, a combination of straight slits, a combination of curved slits or a combination of straight slit(s) and curved slit(s). For example, the film structure FS shown in FIG. 1 may be divided into a first flap FL1 and a second flap FL2 by the slit SL (or because of the slit SL), wherein the first flap FL1 and the second flap FL2 may be disposed opposite to each other, and the slit SL may be disposed/formed between the first flap FL1 and the second flap FL2 in horizontal direction. Note that the first flap FL1 and the second flap FL2 may form a flap pair FP in the film structure FS.

In FIG. 1, the flaps FL of the film structure FS has at least one anchor edge AE (or anchor end) anchored on the anchor structure AR and at least one free edge FE (or free end) which is not permanently anchored on any component within the semiconductor device SD1, and the anchor edge(s) AE and the free edge(s) FE of each flap FL may be designed based on requirement(s). For example (as shown in FIG. 1), the slit SL may define a first free edge FE1 of the first flap FL1 and a second free edge FE2 of the second flap FL2, and the slit SL may be disposed/formed between the first free edge FE1 and the second free edge FE2 (i.e., the first free edge FE1 is separated from the second free edge FE2 by the slit SL). For example, the first free edge FE1 of the first flap FL1 may be opposite to the anchor edge AE1 of the first flap FL1, and the second free edge FE2 of the second flap FL2 may be opposite to the anchor edge AE2 of the second flap FL2, but not limited thereto.

The semiconductor device SD1 may include an actuator ATR configured to actuate the film structure FS, wherein the actuator ATR may overlap the film structure FS in the direction Z. For instance, the actuator ATR shown in FIG. 1 may include a first actuating portion ATR1 disposed on the first flap FL1 and a second actuating portion ATR2 disposed on the second flap FL2. The actuator ATR may have a monotonic electromechanical converting function with respect to the movement of the film structure FS along the direction Z. For instance, the actuator ATR may include a piezoelectric actuator, an electrostatic actuator, a nanoscopic-electrostatic-drive (NED) actuator, an electromagnetic actuator or any other suitable actuator. For example, in FIG. 1, the actuator ATR may be a piezoelectric actuator and include two electrodes E1 and E2 and an actuating layer AL disposed between the electrodes E1 and E2, wherein the actuating layer AL includes suitable piezoelectric material (e.g., lead zirconate titanate, PZT), but not limited thereto.

In the present invention, at least one protruding structure PS may be disposed on (or adjacent to) the free edge FE of a portion of the film structure FS (e.g., the free edge FE of the flap FL), wherein the protruding structure PS may be configured to enhance/raise a thickness of the free edge FE, compared to the thickness of the flap FL near or adjacent to the anchor edge(s) AE, in the cross sectional view (e.g., the protruding structure PS may overlap the free edge FE in the direction Z). The protruding structure PS may have suitable thickness, and the slit SL may be between two protruding structures PS (in the horizontal direction). In FIG. 1, a first protruding structure PS1 is disposed adjacent to the first free edge FE1 and configured to enhance/raise a thickness of the first free edge FE1 in the cross sectional view, and a second protruding structure PS2 is disposed adjacent to the second free edge FE2 and configured to enhance/raise a thickness of the second free edge FE2 in the cross sectional view.

The position of the protruding structure PS may be designed based on requirement(s). In FIG. 1, the protruding structures PS (e.g., the first protruding structure PS1 and the second protruding structure PS2) may be disposed by/at or adjacent to the free edge(s) FE. The protruding structures PS may also be disposed on the same side of the film structure FS in the cross sectional view. For example, as shown in FIG. 1, the protruding structures PS may be disposed above the film structure FS, but not limited thereto. For instance, a cross-sectional geometry/shape of the protruding structure PS is not limited, which may be a quadrangle (e.g., a rectangle, a trapezoid) but not limited thereto. As long as the protruding structure PS can raise a thickness of slit edge (i.e., the thickness of the free edge defined by the slit), requirement(s) of the protruding structure PS in the present invention is satisfied, which is within the scope of the present invention.

The protruding structure PS may include suitable material(s), and the protruding structure PS may be a single-layer structure or a multi-layer structure. For instance, the protruding structure PS may include silicon (e.g., single crystalline silicon or poly-crystalline silicon), silicon compound (e.g., silicon carbide, silicon oxide), germanium, germanium compound, gallium, gallium compound (e.g., gallium nitride or gallium arsenide), other suitable material or a combination thereof, but not limited thereto. For instance, the protruding structure PS may be formed of an insulating material, but not limited thereto. For instance, the film structure FS and the protruding structure PS may be formed of the same material, but not limited thereto.

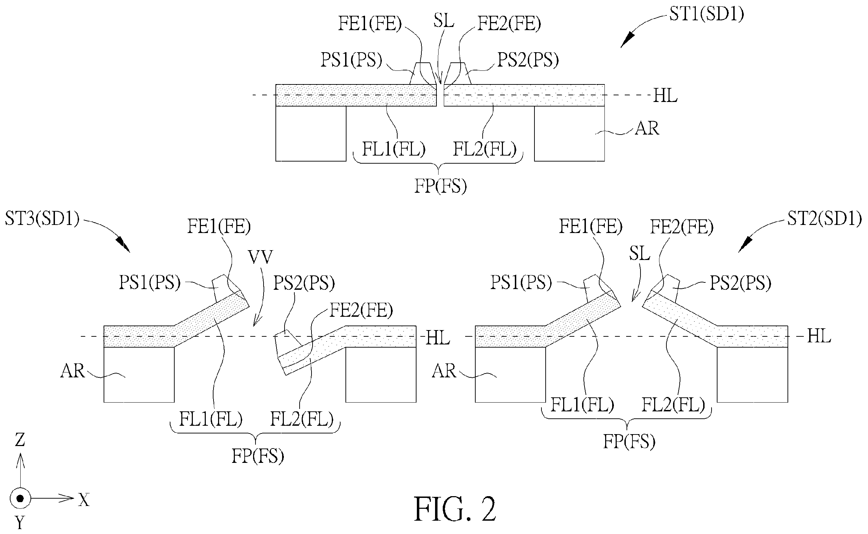

In the operation of the semiconductor device SD1, the film structure FS (the flap pair FP) is actuated/controlled by the actuator ATR. In this embodiment, the film structure FS may be actuated to have a movement toward the direction Z, such that the film structure FS may be transformed among a first state ST1, a second state ST2 and a third state ST3 shown in FIG. 2.

In the first state ST1 of FIG. 2, the position of the film structure FS (the flap pair FP) may be (substantially) horizontal in the cross sectional view (this position may be aligned with a horizontal level HL), and/or the first free edge FE1 of the first flap FL1 and the second free edge FE2 of the second flap FL2 may be partially or fully overlapped with each other in the horizontal direction. Thus, a virtual valve VV (or an opening) related to the slit SL is temporarily closed or considered to be closed in the first state ST1, such that the air may be hard to flow to pass through a space between the first free edge FE1 and the second free edge FE2 (i.e., a space between two opposite sidewalls of the slit SL), thereby making the virtual valve VV have the larger acoustic impedance or flowing resistance in the first state ST1. In the condition "the virtual valve VV is closed", the acoustic impedance or flowing resistance of the virtual valve VV is large or larger than a threshold.

In the first state ST1, since a size of the gap of the slit SL (or a width of the slit SL) should be sufficiently small, the airflow through the gap (i.e., a narrow channel) can be highly damped due to viscous forces/resistance along the walls of the airflow pathways, known as boundary layer effect within field of fluid mechanics. Accordingly, the airflow flowing through the slit SL in the first state ST1 is significantly small or negligible. In other words, when the semiconductor device SD1 is in the first state ST1, the virtual valve VV is closed and even sealed. The size of the gap of the slit SL (or a width of the slit SL) may be designed based on requirement(s). For instance, the size of the gap of the slit SL (or a width of the slit SL) may be less than or equal to 5 µm, less than or equal to 3 µm, or less than or equal to 2 µm, or may range from 1 µm to 2 µm, but not limited thereto.

In the second state ST2 of FIG. 2, the flaps FL may be actuated to be bent toward the same direction, such that the first free edge FE1 and the second free edge FE2 may be simultaneously above or simultaneously below a certain horizontal level (e.g., the horizontal level HL). For example, in the second state ST2, a distance between the first free edge FE1 and this horizontal level HL may be the same as a distance between the second free edge FE2 and this horizontal level HL. For example, the first free edge FE1 and the second free edge FE2 may be partially or fully overlapped with each other in the horizontal direction. In the second state ST2, the virtual valve VV may be temporarily closed, such that the air may be hard to flow to pass through a space between the first free edge FE1 and the second free edge FE2 (i.e., a space between two opposite sidewalls of the slit SL), thereby making the virtual valve VV have the larger flowing resistance in the second state ST2.

In the second state ST2 of FIG. 2, since the virtual valve VV is temporarily closed and has the larger flowing resistance, the air pressures on two opposite sides of the film structure FS are different to cause an air-pressure difference. Namely, the film structure FS forms an air pressure variation when the film structure FS is in the second state ST2 and/or the film structure FS is actuated to be transformed to the second state ST2. Note that the air pressure variation is formed at a pressure variant frequency.

In the third state ST3 of FIG. 2, the flaps FL may be actuated to be bent toward the opposite directions (e.g., the first flap FL1 may be actuated to be bent toward the direction Z while the second flap FL2 may be actuated to be bent toward a direction opposite to the direction Z), such that the first free edge FE1 and the second free edge FE2 may be on the opposite sides of a certain horizontal level (e.g., the horizontal level HL). For example, in the third state ST3, a distance between the first free edge FE1 and this horizontal level HL may be the same as a distance between the second free edge FE2 and this horizontal level HL.

In the third state ST3, the first free edge FE1 and the second free edge FE2 may not overlap in the horizontal direction to make a difference ΔU_{z} between a displacement U_{z,FL1} of the first free edge FE1 and a displacement U_{z,FL2} of the second free edge FE2 (e.g., ΔU_{z} = |U_{z,FL1} - U_{z,FL2}|) be greater than the thickness of the first free edge FE1 (and/or the thickness of the second free edge FE2). Thus, the virtual valve VV related to the slit SL may be temporarily formed (opened), such that the air may easily flow to pass through a space between the first free edge FE1 and the second free edge FE2 (i.e., a space between two opposite sidewalls of the slit SL), thereby making the virtual valve VV have the lower flowing resistance in the third state ST3. Namely, the virtual valve VV is formed because of the slit SL. Note that the virtual valve VV is formed at a valve opening frequency. In the condition "the virtual valve VV is formed/opened", the flowing resistance of the virtual valve VV is low or lower than another threshold.

In the third state ST3, if the air-pressure difference exists between two opposite sides of the film structure FS, the air naturally flows to pass through the virtual valve VV due to the lower flowing resistance of the virtual valve VV and this air-pressure difference, such that the airflow and/or the air pulse can be generated. In some embodiments, during a time segment that the film structure FS is in the third state ST3, the airflow passes through the virtual valve VV.

According to the above, due to the actuation of the film structure FS, the virtual valve VV related to the slit SL may be formed/opened or closed (i.e., the film structure FS may be configured to form/open or close the virtual valve VV), and the airflow, the air pulse and/or the acoustic wave may be generated.

In some embodiments, the film structure FS may be actuated to perform a common mode movement and a differential mode movement to transform its state, wherein the film structure FS may perform the common mode movement to make the first flap FL1 and the second flap FL2 be simultaneously actuated to move toward the same direction, and the film structure FS may perform the differential mode movement to make the first flap FL1 and the second flap FL2 be simultaneously actuated to move toward opposite directions. For example, the film structure FS may be in the second state ST2 by performing the common mode movement (i.e., the film structure FS may perform the common mode movement to form the air pressure variation), and the film structure FS may be in the third state ST3 by performing the differential mode movement (i.e., the film structure FS may perform the differential mode movement to form the virtual valve VV), but not limited thereto. For example, the film structure FS may be actuated to perform the common mode movement and the differential mode movement simultaneously, but not limited thereto.

In the present invention, the actuator ATR may receive any suitable signal to actuate the film structure FS. In some embodiments, the film structure FS may be actuated by a modulation driving signal (also referred as a pressure driving signal in some cases) to perform the common mode movement and/or be in the second state ST2, and the film structure FS may be actuated by a demodulation driving signal (also referred as a valve driving signal in some cases) to perform the differential mode movement and/or be in the third state ST3. In some embodiments, the actuator ATR may receive the modulation driving signal and the demodulation driving signal at different times, but not limited thereto.

Note that, the first state ST1, the second state ST2 and the third state ST3 are just for illustrative purposes, which is not limited thereto. Operations of the semiconductor device of the present invention may be referred to US Patent No. 11,399,228, Patent No. 11,943,585, US Application No. 19/007,580, Application No. 19/424,094, Application No. 19/446,931. Content of which is included by reference and not narrated herein for brevity.

For instance, in an embodiment disclosed in US 11,943,585 filed by Applicant, the electrodes E1 and E2 of the actuator ATR receive the demodulation (valve) driving signal and the modulation (pressure) driving signal (e.g., the electrode E2 receives the demodulation (valve) driving signal, and the electrode E1 receives the modulation (pressure) driving signal), but not limited thereto. The modulation (pressure) driving signal drives the film structure FS to perform the common mode movement. The demodulation (valve) driving signal drives the film structure FS to perform a differential mode movement.

In an operation of a semiconductor device of the prior art, unwanted backflow would be formed when the virtual valve is opened or closed at an incorrect time or the virtual valve is not opened or closed well, thereby producing adverse effect(s) in the operation of the semiconductor device of the prior art. In some cases, because the flaps of the prior art are too thin, if the virtual valve of the prior art is opened widely for the high airflow, large air pulse and/or high sound pressure level (SPL), this virtual valve is closed for an insufficient amount of time. However, in the present invention, as shown in FIG. 1 and FIG. 2, since the protruding structures PS exist for enhancing the thicknesses of the free edges FE, the free edges FE may be easily overlapped with each other (in the horizontal direction), such that the virtual valve VV may be precisely opened or closed at the correct time, and the virtual valve VV may be opened or closed well, thereby reducing the unwanted backflow during the operation. Furthermore, the time required to close the virtual valve VV may be reduced due to the existences of the protruding structures PS. On the other hand, since the semiconductor device SD1 of the present invention has the protruding structures PS rather than uniformly increases the thicknesses of the flaps FL, the flaps FL maintain their well mobility and still generate high airflow, large air pulse and/or high SPL. In addition, the protruding structures PS may improve the tolerance to undesired leaks during operation and actuation.

In the embodiment that the semiconductor device SD1 is an APG device, the film structure FS may be configured to be actuated to produce a plurality of air pulses, and the air pulses may be produced due to the change of the state of the film structure FS. In some embodiments, a flowing direction of the air pulse and/or a flowing direction of the airflow formed of the air pulses may be reversible. In some embodiments, the air pulse may be asymmetric.

In addition, the air pulses may be produced at a suitable pulse rate. Also, the pressure variant frequency of the air pressure variation and the valve opening frequency of the virtual valve VV may be synchronous with this pulse rate. For example, the film structure FS (flap pair FP) may operate at an ultrasonic frequency, such that the air pulses may be produced at an ultrasonic pulse rate, and the pressure variant frequency and the valve opening frequency may be synchronous with this ultrasonic pulse rate, but not limited thereto.

Furthermore, the modulation driving signal and the demodulation driving signal may be related to an output amplitude of the air pulse, and a modulation frequency of the modulation driving signal and a demodulation frequency of the demodulation driving signal may be related to the pulse rate of the air pulses. For example, the modulation frequency and the demodulation frequency may be synchronous with the pulse rate of the air pulse, the pressure variant frequency of the air pressure variation and the valve opening frequency of the virtual valve VV, but not limited thereto.

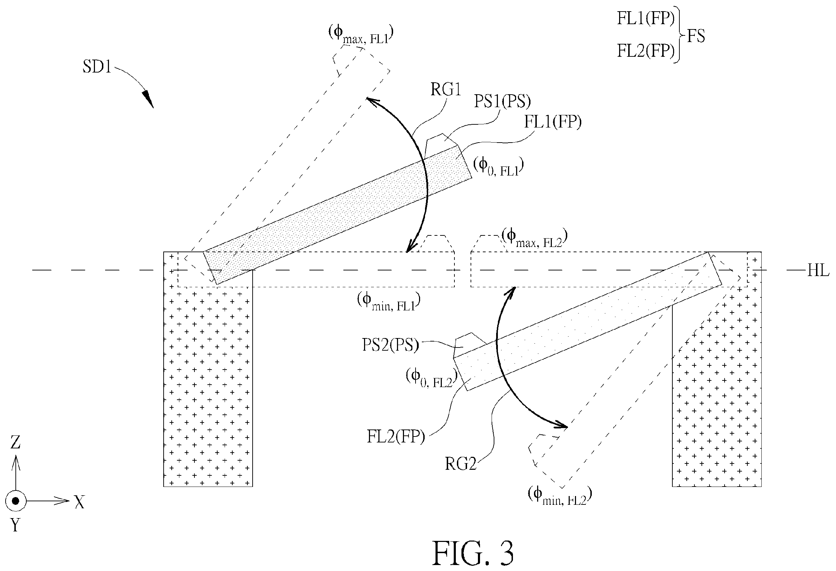

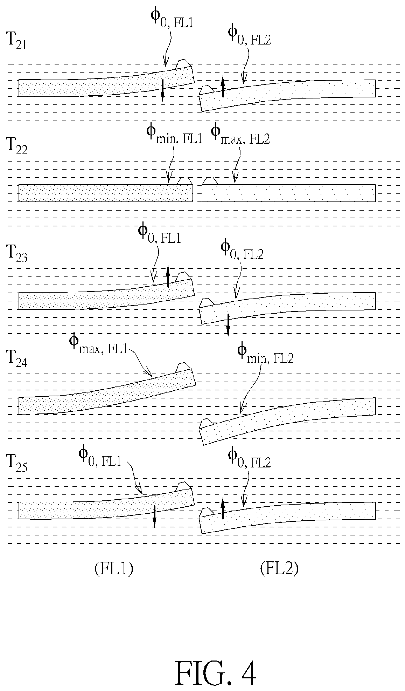

An embodiment that the semiconductor device SD1 is an APG device related to an asymmetric deflection (taught in Application No. 19/424,094) is shown in FIG. 3 and FIG. 4. As shown in FIG. 3, the flap pair FP (film structure FS) of the semiconductor device SD1 (the APG device) possesses an initial deflection difference or exhibits an average displacement difference between the first flap FL1 and the second flap FL2, during the operation of the semiconductor device SD1.

In the embodiment shown in FIG. 3, the first flap FL1 is actuated to be bent toward the direction Z (bent upwards) and the second flap FL2 is actuated to be bent toward a direction opposite to the direction Z (bent downwards). When the semiconductor device SD1 is imposed asymmetric initial deflection, the first flap FL1 initially deflects at an initial position ϕ_{0,FL1}, and the second flap FL2 initially deflects at an initial position ϕ_{0,FL2}, so as to prepare for performing the differential mode movement. Furthermore, the first flap FL1 swings over a swing range RG1 between positions ϕ_{min,FL1} and ϕ_{max,FL1}, and the second flap FL2 swings over a swing range RG2 between positions ϕ_{min,FL2} and ϕ_{max,FL2} (i.e., a first average displacement corresponding to the first flap FL1 is different from a second average displacement corresponding to the second flap FL2). Namely, the positions ϕ_{min,FL1} and ϕ_{max,FL1} are reversal/turning/extreme points of the first flap FL1, and the positions ϕ_{min,FL2} and ϕ_{max,FL2} are reversal/turning/extreme points of the second flap FL2. Herein, ϕ may be considered as (angular) position of tip of this flap FL with respect to its anchor.

In one embodiment, the position ϕ_{min,FL1} and the position ϕ_{max,FL2} may be aligned with a certain horizontal level HL shown in FIG. 3. The swing range RG1 of the first flap FL1 is (substantially) above the horizontal level HL and the swing range RG2 of the second flap FL2 is (substantially) below the horizontal level HL.

Accordingly, an initial deflection difference or an average displacement difference (i.e., a difference between the first average displacement and the second average displacement) exist between the first flap FL1 and the second flap FL2, wherein both initial deflection difference and average displacement difference are larger than the thickness of the film structure FS and the thicknesses of the free edges FE.

In the asymmetric deflection, the virtual valve VV is considered as closed when the first flap FL1 swings to the position ϕ_{min,FL1} and the second flap FL2 swings to the position ϕ_{max,FL2} (the film structure FS is in the first state ST1), and the virtual valve VV is considered as formed when the first flap FL1 swings to the position ϕ_{max,FL1} and the second flap FL2 swings to the position ϕ_{min,FL2} (the film structure FS is in the third state ST3). Namely, the virtual valve VV is closed when the first flap FL1 is around/at the position ϕ_{min,FL1} (the reversal/turning/extreme point) and the second flap FL2 is around/at the position ϕ_{max,FL2} (the reversal/turning/extreme point), and the virtual valve VV is formed when the first flap FL1 is around/at the position ϕ_{max,FL1} (the reversal/turning/extreme point) and the second flap FL2 is around/at the position ϕ_{min,FL2} (the reversal/turning/extreme point).

For example, in one moving cycle of the asymmetric deflection (e.g., FIG. 4), the first flap FL1 starts from the position ϕ_{0,FL1} (time T₂₁) and move to the positions ϕ_{min,FL1} ϕ_{0,FL1}, ϕ_{max,FL1} and ϕ_{0,FL1} in sequence (corresponding to times T₂₂, T₂₃, T₂₄ and T₂₅, respectively), and the second flap FL2 starts from the position ϕ_{0,FL2} (time T₂₁) and move to the positions ϕ_{max,FL2}, ϕ_{0,FL2}, ϕ_{min,FL2} and ϕ_{0,FL2} in sequence (corresponding to times T₂₂, T₂₃, T₂₄ and T₂₅, respectively), such that the film structure FS may be considered as being transformed among the first state ST1 and the third state ST3, from the perspective of differential mode movement. In this moving cycle of the asymmetric deflection, the virtual valve VV may be closed only once within one moving cycle. For example, because the virtual valve VV may be closed only once in one moving cycle, the pressure variant frequency corresponding to the common mode movement and the valve opening frequency corresponding to the differential mode movement may be the same.

In the scheme of the asymmetric deflection, the first flap FL1 and the second flap FL2 may be respectively driven by the first valve driving signal and the second valve driving signal which are biased at different bias voltages (i.e., a first bias voltage of the first valve driving signal is different from a second bias voltage of the second valve driving signal). Because the first bias voltage and the second bias voltage are different, the initial deflection of the first flap FL1 and the initial deflection of the second flap FL2 are quite different.

In the asymmetric deflection, as taught in Application No. 19/424,094 and Application No. 19/446,931, the first valve driving signal has a first polarity with respect to the first bias voltage, the second valve driving signal has a second polarity with respect to the second bias voltage, and the first polarity and the second polarity are opposite to each other. For example, during a time segment between times T₂₁ and T₂₂, the first valve driving signal may have the negative polarity with respect to the first bias voltage, and the second valve driving signal may have the positive polarity with respect to the second bias voltage, such that the first flap FL1 swings to the position ϕ_{min,FL1} and the second flap FL2 swings to the position ϕ_{max,FL2}, so as to close the virtual valve VV.

Details of the driving signals of the asymmetric deflection and the effect of the asymmetric deflection may be referred to US Application No. 19/424,094 filed by Applicant, which are not narrated herein for brevity.

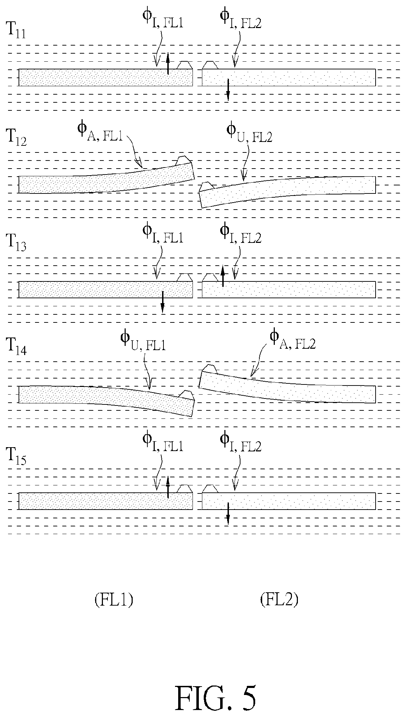

In addition to the asymmetric deflection, an embodiment that the semiconductor device SD1 is an APG device related to a symmetric deflection (taught in Patent No. 11,943,585) is shown in FIG. 5. In FIG. 5, the film structure FS (the flap pair FP) may be in the first state ST1 initially, such that the first flap FL1 and the second flap FL2 may respectively start from the positions ϕ_{I,FL1} and ϕ_{I,FL2} aligned with the horizontal level HL. The first flap FL1 may be actuated between a position ϕ_{A,FL1} above the position ϕ_{I,FL1} and a position ϕ_{U,FL1} under the position ϕ_{I,FL1}, and the second flap FL2 may be actuated between a position ϕ_{A,FL2} above the position ϕ_{I,FL2} and a position ϕ_{U,FL2} under the position ϕ_{I,FL2}. Thus, the average displacement of the first flap FL1 and the average displacement of the second flap FL2 are (substantially) the same, and the initial deflection of the first flap FL1 and the initial deflection of the second flap FL2 are (substantially) the same.

For example, in one moving cycle of the symmetric deflection (e.g., FIG. 5), the first flap FL1 starts from the position ϕ_{I,FL1} (time T₁₁) and move to the positions ϕ_{A,FL1}, ϕ_{I,FL1}, ϕ_{U,FL1} and ϕ_{I,FL1} in sequence (corresponding to times T₁₂, T₁₃, T₁₄ and T₁₅, respectively), and the second flap FL2 starts from the position ϕ_{I,FL2} (time T₁₁) and move to the positions ϕ_{U,FL2}, ϕ_{I,FL2}, ϕ_{A,FL2} and ϕ_{I,FL2} in sequence (corresponding to times T₁₂, T₁₃, T₁₄ and T₁₅, respectively), such that the film structure FS may be transformed among the first state ST1 and the third state ST3, from the perspective of differential mode movement.

In the scheme of the asymmetric deflection, the first flap FL1 and the second flap FL2 may be respectively driven by the first valve driving signal and the second valve driving signal which are biased at the same bias voltage. Also, in some time segments, the first valve driving signal has the first polarity with respect to the bias voltage, the second valve driving signal has the second polarity with respect to the bias voltage, and the first polarity and the second polarity are opposite to each other.

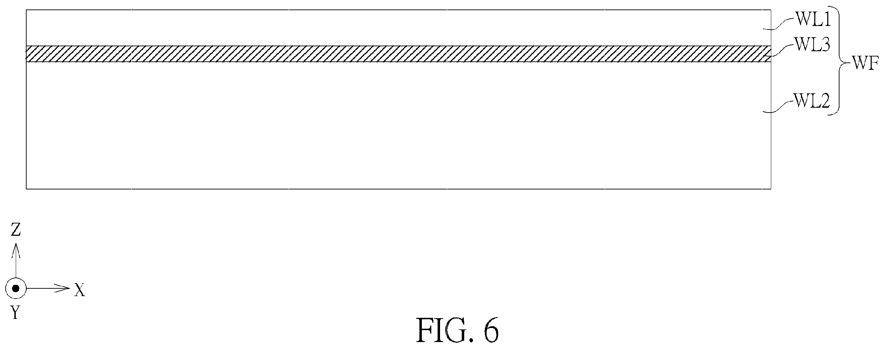

In the following, a manufacturing method of the aforementioned semiconductor device SD1 (e.g., aforementioned APG device) is described, wherein the semiconductor device SD1 of the present invention may be manufactured by any suitable process. For example, an embodiment of a manufacturing method of the aforementioned semiconductor device SD1 is shown in FIG. 6 to FIG. 11, wherein FIG. 6 to FIG. 11 are cross sectional view schematic diagrams illustrating structures at different stages of the manufacturing method of the semiconductor device SD1. Note that the manufacturing method of the semiconductor device SD1 of the present invention is not limited by the following embodiments and figures. In some embodiments, any other suitable step may be added (or removed) before (or after) one of the existing steps of the manufacturing method, and/or some steps may be performed simultaneously or separately. In some embodiments, the process sequence of the manufacturing method may be adjusted based on practical requirement(s).

For example, the semiconductor device SD1 may be formed by at least one semiconductor manufacturing process, such that the semiconductor device SD1 may be a MEMS chip including a MEMS structure, but not limited thereto. In the following manufacturing method of the semiconductor device SD1, a forming process of a layer and/or a structure may include an atomic layer deposition (ALD), a chemical vapor deposition (CVD), a physical vapor deposition (PVD), a coating process, any other suitable process or a combination thereof, but not limited thereto. In the following manufacturing method of the semiconductor device SD1, a patterning process may include a photolithography, an etching process, any other suitable process or a combination thereof, wherein the etching process may be a wet etching process, a dry etching process, any other suitable etching process or a combination thereof, but not limited thereto.

As shown in FIG. 6, a wafer WF is provided, wherein the wafer WF may include a first layer WL1 and a second layer WL2, and may optionally include a wafer insulating layer WL3 between the first layer WL1 and the second layer WL2.

The first layer WL1, the wafer insulating layer WL3 and the second layer WL2 may individually include any suitable material, such that the wafer WF may be any suitable type. For instance, the first layer WL1 and the second layer WL2 may individually include silicon (e.g., single crystalline silicon or poly-crystalline silicon), silicon compound (e.g., silicon carbide, silicon oxide), germanium, germanium compound, gallium, gallium compound (e.g., gallium nitride or gallium arsenide), other suitable material or a combination thereof. For instance, the wafer insulating layer WL3 may include oxide, such as silicon oxide (e.g., silicon dioxide), but not limited thereto. For example, the first layer WL1 may include single crystalline silicon, and the wafer insulating layer WL3 may include oxide, such that the wafer WF may be a silicon-on-insulator (SOI) wafer, but not limited thereto.

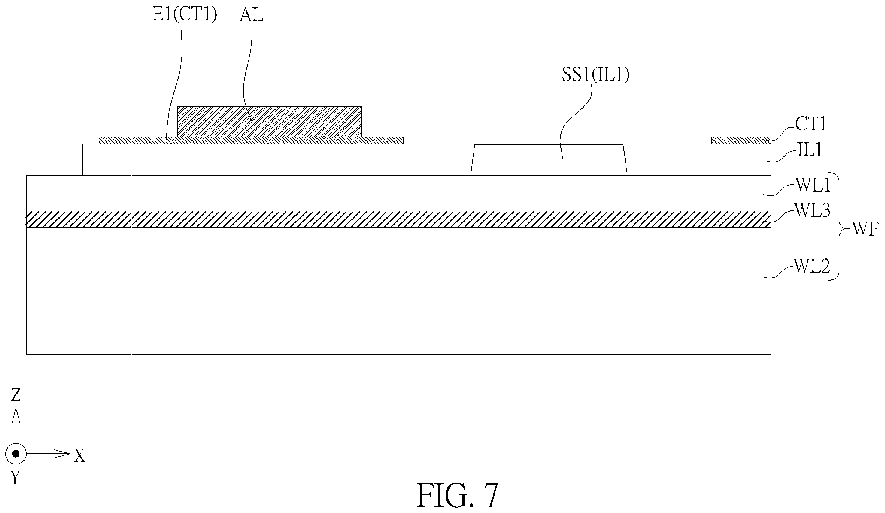

After the step shown in FIG. 6, a first insulation layer (e.g., IL1), a first conductive layer (e.g., CT1) and an actuating layer (e.g., AL) may be formed on the wafer WF and patterned, and a cross sectional view is shown in FIG. 7.

In FIG. 7, a patterned first insulating layer IL1 may be formed on an upper side of the wafer WF, such that the first layer WL1 is between the first insulating layer IL1 and the second layer WL2. The material contained in the first insulating layer IL1 may be designed based on practical requirement(s). For example, the first insulating layer IL1 may include oxide (e.g., silicon oxide, compensation oxide), but not limited thereto.

In FIG. 7, the first insulating layer IL1 may further include a first sub-structure SS1. For example, the first sub-structure SS1 may be disposed at a position where the protruding structures PS and the slit SL are subsequently formed.

In FIG. 7, a patterned first conductive layer CT1 and a patterned actuating layer AL may be formed on the upper side of the wafer WF (on the first layer WL1) in sequence, such that the first conductive layer CT1 may be between the actuating layer AL and the first layer WL1. In FIG. 7, the first conductive layer CT1 may be between the actuating layer AL and the first insulating layer IL1. The first conductive layer CT1 may include any suitable conductive material. For example, the first conductive layer CT1 may include metal (e.g., platinum (Pt)), but not limited thereto.

For example, the first insulating layer IL1, the first conductive layer CT1 and the actuating layer AL may be formed in sequence, and then, the actuating layer AL, the first conductive layer CT1 and the first insulating layer IL1 may be patterned in sequence, but not limited thereto.

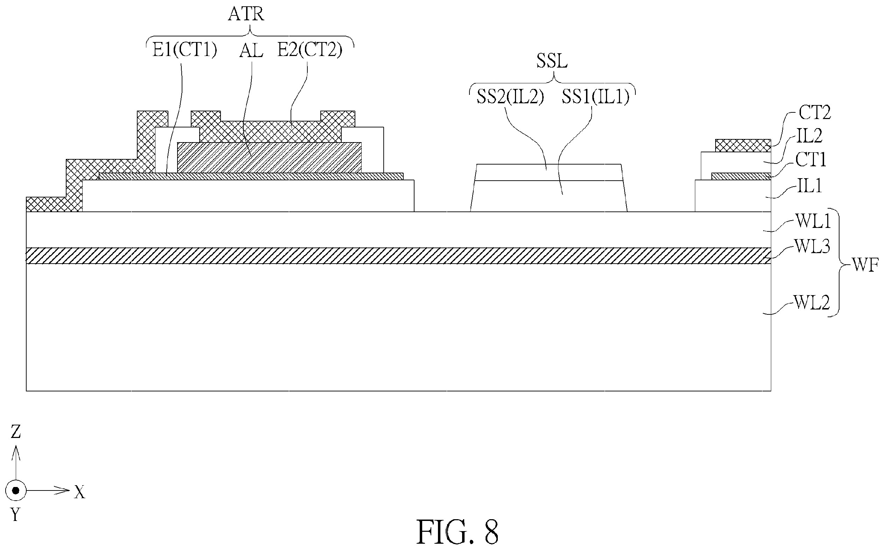

As shown in FIG. 8, a second insulating layer IL2 may be formed on the actuating layer AL and be patterned. The material of the second insulating layer IL2 may be designed based on requirement(s). For instance, the second insulating layer IL2 may include oxide, but not limited thereto.

In FIG. 8, the second insulating layer IL2 may further include a second sub-structure SS2. For example, the second sub-structure SS2 may be disposed at a position where the protruding structures PS and the slit SL are subsequently formed. In FIG. 8, the first sub-structure SS1 and the second sub-structure SS2 are overlapped with each other, and a structure layer SSL is formed of the first sub-structure SS1 and the second sub-structure SS2.

Note that, the second sub-structure SS2 may be optional/adaptive within the structure layer SSL. In an embodiment, the second sub-structure SS2 may be used to adjust the thickness of the free edge of the flap. In some embodiments, the second sub-structure SS2 may be omitted, which is also within the scope of the present invention.

As shown in FIG. 8, a second conductive layer CT2 may be formed on the actuating layer AL and the second insulating layer IL2, and then, the second conductive layer CT2 may be patterned. The material of the second conductive layer CT2 may be designed based on requirement(s). For instance, the second conductive layer CT2 may include metal (e.g., aluminum-copper (AlCu) or titanium nitride (TiN)), but not limited thereto. Note that the second insulating layer IL2 may be configured to separate at least a portion of the first conductive layer CT1 from at least a portion of the second conductive layer CT2.

In FIG. 8, the actuator ATR may be formed of the actuating layer AL, the electrode E1 belonging to the first conductive layer CT1 and the electrode E2 belonging to the second conductive layer CT2. Thus, the actuator ATR may be formed on the first layer WL1 of the wafer WF.

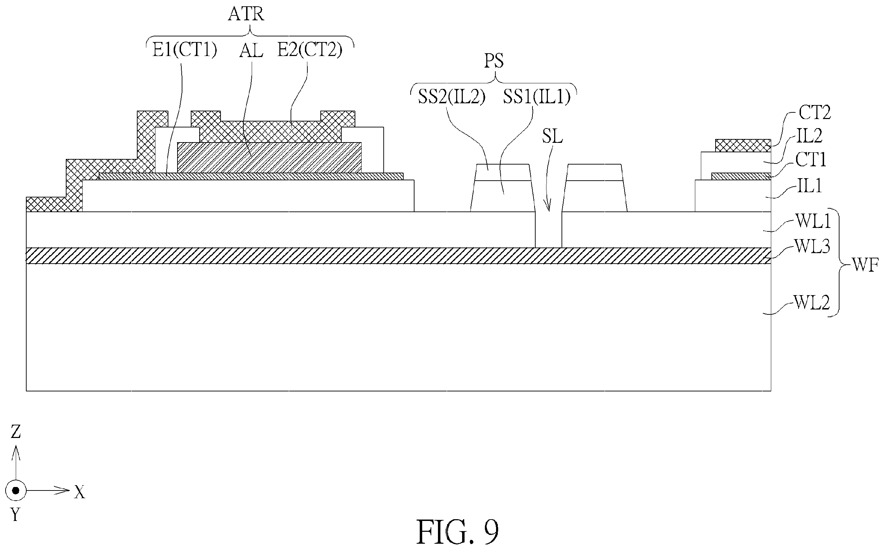

As shown in FIG. 9, the structure layer SSL may be patterned to form the protruding structures PS (e.g., the first protruding structure PS1 and the second protruding structure PS2), and then, the first layer WL1 of the wafer WF may be patterned to form the slit SL (i.e., the slit SL penetrates the first layer WL1), wherein the slit SL may be between two protruding structures PS in the horizontal direction. In FIG. 9, the slit SL is a portion where the first layer WL1 is removed/etched.

In the present invention, the structure layer SSL and the first layer WL1 may be patterned by any suitable process. For example, the structure layer SSL and the first layer WL1 may be patterned in the same patterning process, such that the same etch stop layer may be used in the step of patterning the first layer WL1 and the step of patterning the structure layer SSL, but not limited thereto. For example, the protruding structures PS may be formed (e.g., the structure layer SSL may be patterned) before forming the second conductive layer CT2, and the first layer WL1 may be patterned after forming the second conductive layer CT2, but not limited thereto.

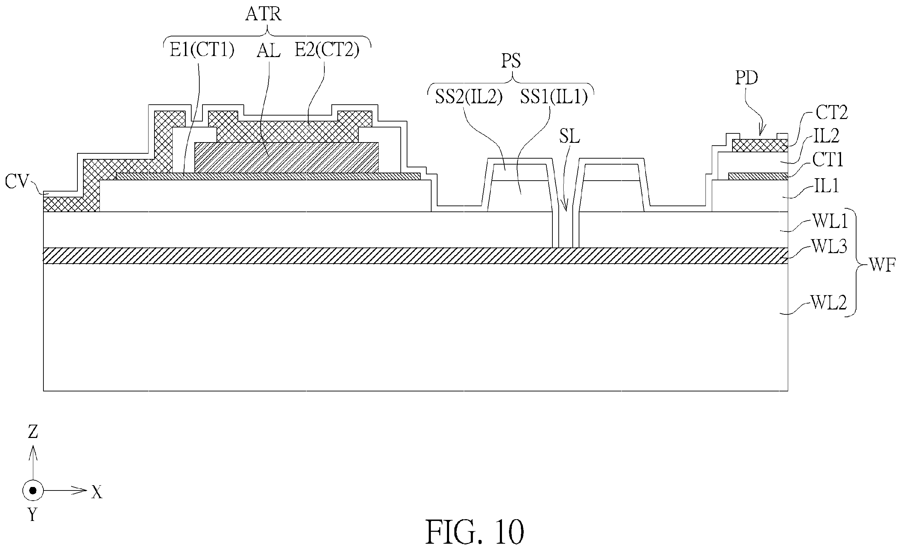

Optionally, as shown in FIG. 10, a covering layer CV may be formed on the second conductive layer CT2, the second insulating layer IL2 and the wafer WF by any suitable process (e.g., the ALD process), and then, the covering layer CV may be patterned, wherein the covering layer CV may include any suitable insulating material (e.g., aluminum oxide). Furthermore, in FIG. 10, after patterning the covering layer CV, a part of the second conductive layer CT2 which is not covered by the covering layer CV may serve as a pad PD.

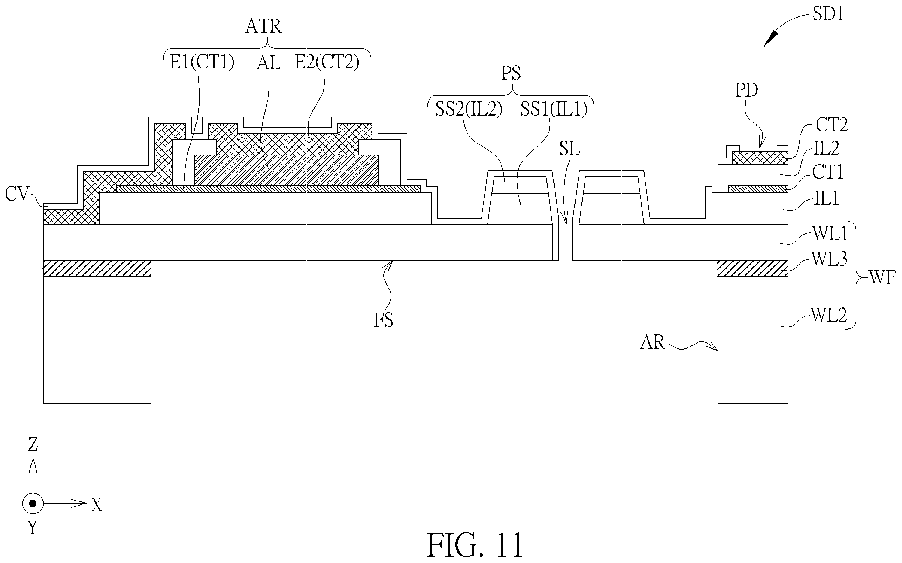

As shown in FIG. 11, the second layer WL2 of the wafer WF may be patterned, so as to make a portion of the first layer WL1 be released from the second layer WL2 to serve as the film structure FS (i.e., the film structure FS is formed in the first layer WL1). In detail, the second layer WL2 of the wafer WF may have a first part and a second part, the first part of the second layer WL2 may be removed, and the second part of the second layer WL2 may be remained, wherein a portion of the first layer WL1 corresponding to the removed first part of the second layer WL2 in the direction Z may serve or be regarded as the film structure FS, and the second part of the second layer WL2 may serve or be regarded as the anchor structure AR. For example, the first part of the second layer WL2 may be removed by a deep reactive ion etching (DRIE) process, but not limited thereto.

Furthermore, since the wafer insulating layer WL3 of the wafer WF exists, a portion of the wafer insulating layer WL3 corresponding to the first part of the second layer WL2 may be removed after patterning the second layer WL2 of the wafer WF.

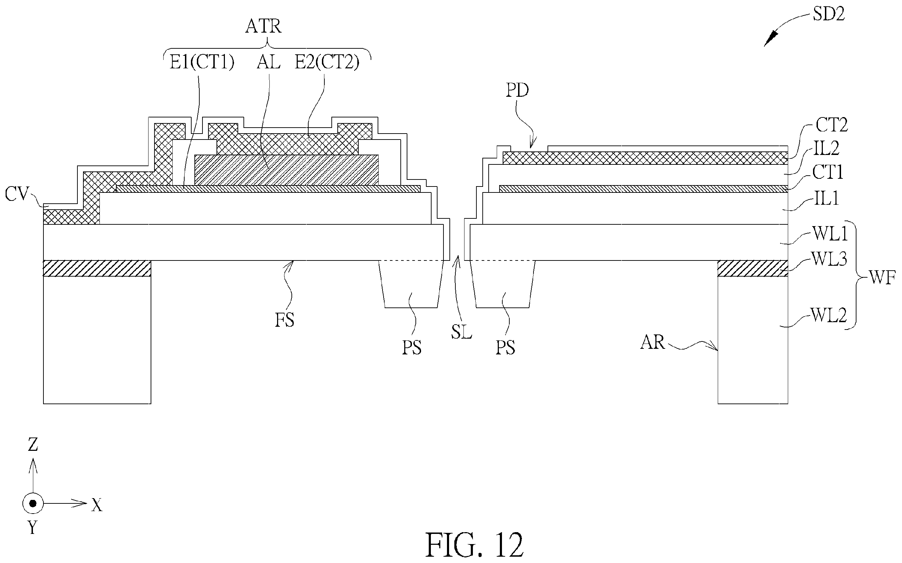

Referring to FIG. 12 to FIG. 17, FIG. 12 to FIG. 17 are cross sectional view schematic diagrams illustrating structures at different stages of a manufacturing method of a semiconductor device according to a second embodiment of the present invention, wherein FIG. 12 shows the final structure of the semiconductor device SD2 according to the second embodiment. As shown in FIG. 12, a difference between this embodiment and the first embodiment is the design/position of the protruding structures PS of the semiconductor device SD2. In FIG. 12, the protruding structures PS may be disposed under the film structure FS.

In the following, a manufacturing method of this semiconductor device SD2 is described, wherein the manufacturing method of this semiconductor device SD2 is not limited by the following embodiments and figures.

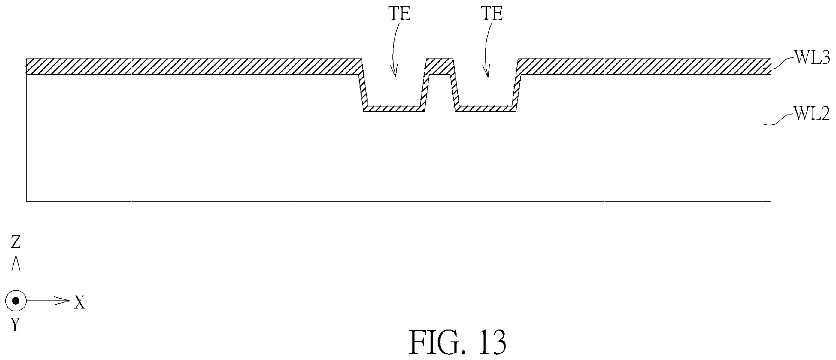

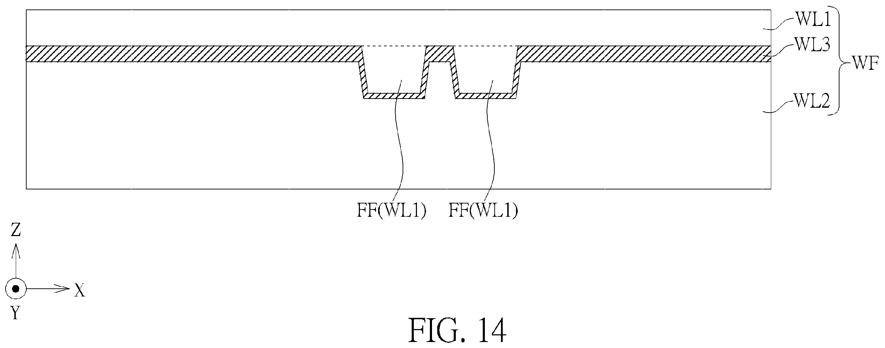

As shown in FIG. 13 and FIG. 14, the wafer WF is provided, wherein the second layer WL2 has a plurality of trenches TE, and a portion of the first layer WL1 is filled in the trenches TE, such that the first layer WL1 has a plurality of filled structures FF formed in the trenches TE. The filled structures FF and the trenches TE may be disposed at positions where the protruding structures PS are subsequently formed. Optionally, since the wafer insulating layer WL3 disposed between the first layer WL1 and the second layer WL2 may exist, a portion of the wafer insulating layer WL3 may be disposed in the trenches TE.

For instance, the formation of the wafer WF may be shown in FIG. 13 and FIG. 14, but the formation of the wafer WF is not limited to FIG. 13 and FIG. 14. In FIG. 13, the trenches TE may be formed on the second layer WL2 by an etching process. Optionally, in FIG. 13, the wafer insulating layer WL3 may be formed on the second layer WL2, such that a portion of the wafer insulating layer WL3 may be disposed in the trenches TE. In FIG. 14, the first layer WL1 may be formed on the second layer WL2 and the wafer insulating layer WL3, wherein a portion of the first layer WL1 may be filled in the trenches TE, such that the first layer WL1 may have the filled structures FF formed in the trenches TE.

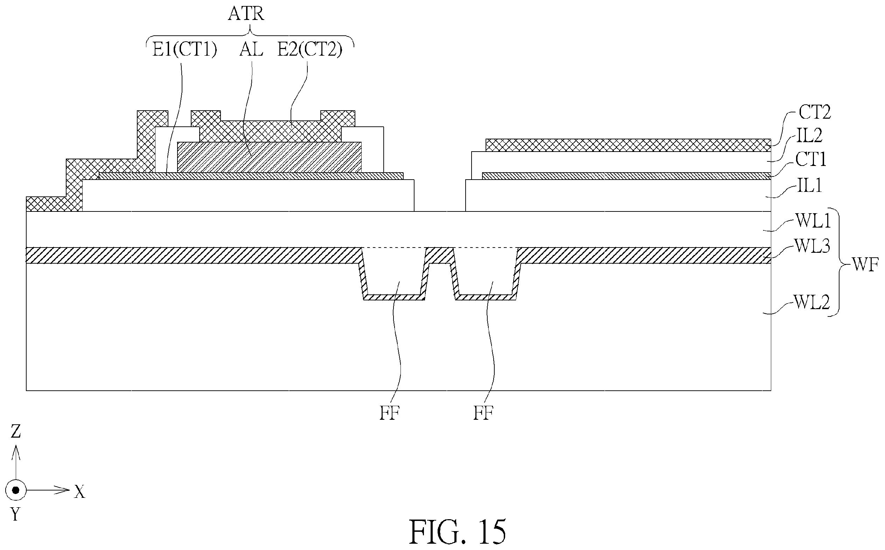

As shown in FIG. 15, similar to the manufacturing method of the semiconductor device SD2 of the first embodiment, the patterned first insulating layer IL1, the patterned first conductive layer CT1, the patterned actuating layer AL, the patterned second insulating layer IL2 and the patterned second conductive layer CT2 are formed on the wafer WF.

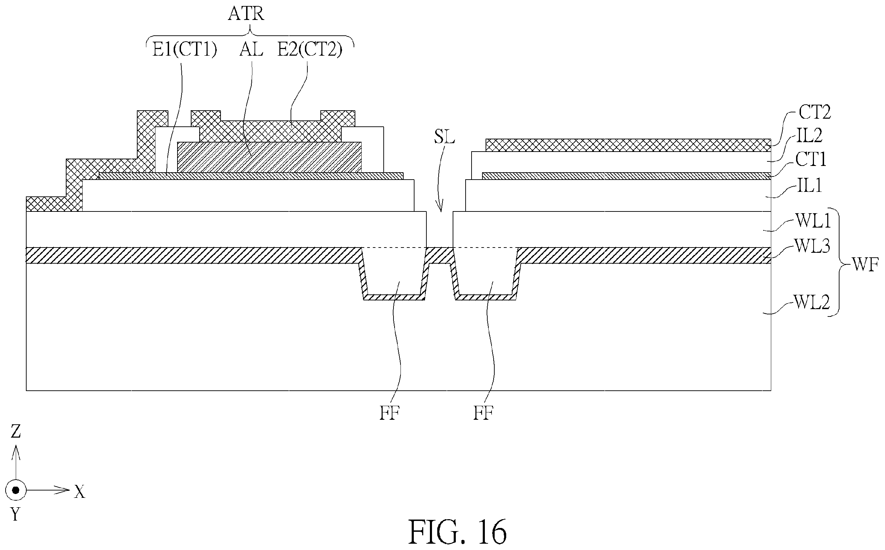

As shown in FIG. 16, the first layer WL1 may be patterned to form the slit SL (i.e., the slit SL penetrates the first layer WL1), wherein the slit SL may be between two filled structures FF in the horizontal direction.

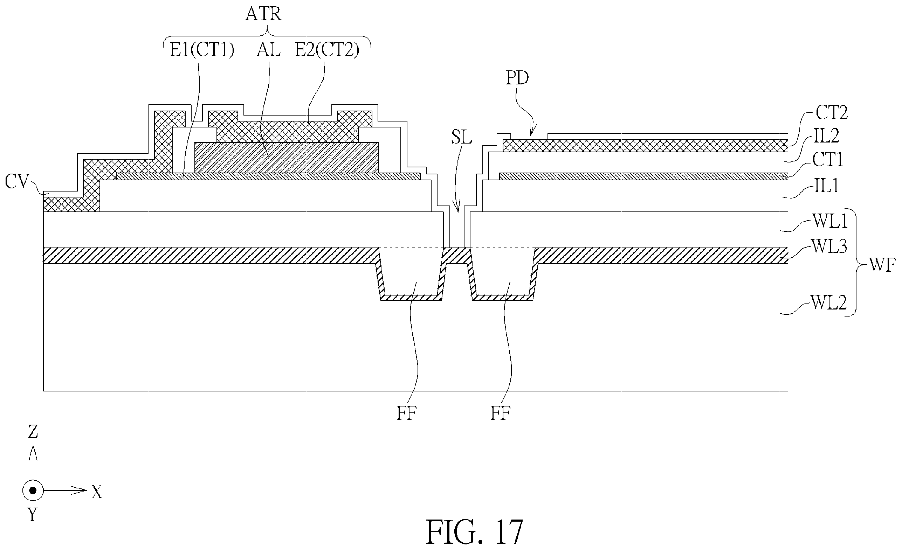

Optionally, as shown in FIG. 17, the patterned covering layer CV may be formed on the second conductive layer CT2, the second insulating layer IL2 and the wafer WF.

Finally, the second layer WL2 of the wafer WF may be patterned, so as to remove the first part of the second layer WL2, as shown in FIG. 12, such that a portion of the first layer WL1 corresponding to the removed first part of the second layer WL2 in the direction Z may be released from the second layer WL2 to serve as the film structure FS (i.e., the film structure FS is formed in the first layer WL1), and the protruding structures PS may be respectively formed of the filled structures FF (i.e., the filled structures FF may be also corresponding to the removed first part of the second layer WL2 in the direction Z). Since the wafer insulating layer WL3 of the wafer WF exists, the wafer insulating layer WL3 may be patterned also.

In this embodiment, since the protruding structure PS is formed of the filled structure FF of the first layer WL1, the film structure FS, the protruding structure PS and the first layer WL1 may be formed of the same material.

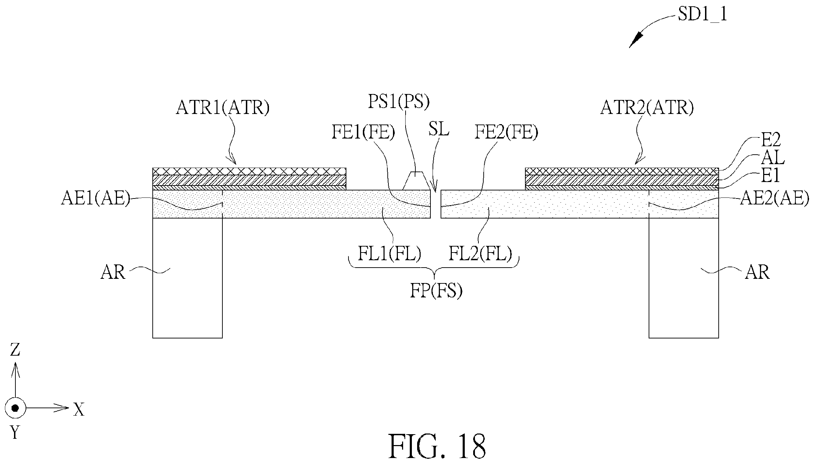

Note that, in the above embodiments, the protruding structure PS is formed on both flaps FL of the flap pair FP, which is not limited thereto. In an embodiment, the protruding structure PS may be formed on one flap FL of the flap pair FP (e.g., the semiconductor device SD1_1 shown in FIG. 18). As long as a thickness on the free edge FE of the flap FL is raised and enhanced, the requirement of the present invention is satisfied, which is within the scope of the present invention.

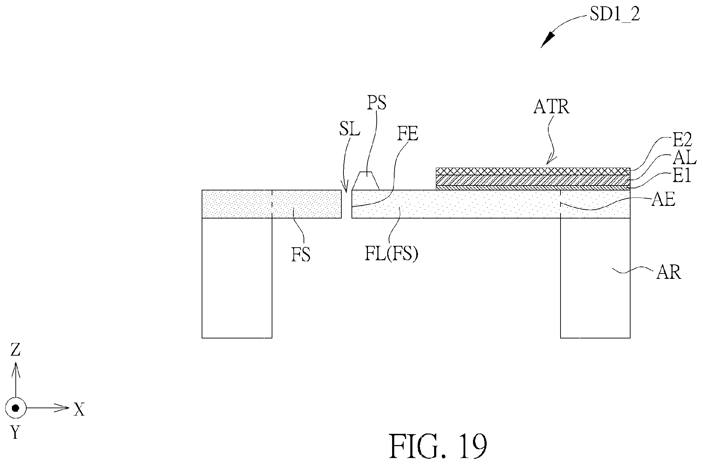

Moreover, the semiconductor device (e.g., the semiconductor device SD1_2 shown in FIG. 19) of the present invention may comprise one flap FL opposite to a portion of the film structure FS. The flap FL may be actuated to move upward/downward relative to the portion of the film structure FS. A virtual valve is formed between the flap FL and portion of the film structure FS. The protruding structure PS may be formed on a free edge FE of the flap FL which is opposite to the portion of the film structure FS, as shown in FIG. 19, so as to raise/enhance the thickness at the free edge FE of the flap FL. In another embodiment (a variant of the semiconductor device SD1_2 shown in FIG. 19), the protruding structure PS may be formed on a free edge of the portion of the film structure FS which is opposite to the free edge FE of the flap FL, so as to raise/enhance the thickness at the free edge of the film structure FS. Given a certain driving signal, a closed duration of the virtual valve may be lengthened, compared to the case without protruding structure. In other words, the duration of the virtual valve being closed may be lengthened due to the thickness brought by the protruding structure PS, which is also within the scope of the present invention.

In summary, since the protruding structure of the present invention exists, the thickness of the free edge of the film structure is enhanced. Thus, during the operation of the semiconductor device, the unwanted backflow is reduced and the tolerance to undesired leaks is improved under the condition that the flaps maintain their well mobility.

## Claims

1. A semiconductor device (SD1, SD2, SD1_1 or SD1_2), **characterized by,** comprising:
a film structure (FS); and
a protruding structure (PS) formed on a free edge (FE) of a portion of the film structure (FS), configured to enhance a thickness of the free edge (FE) in a cross sectional view.

2. The semiconductor device (SD1 or SD2) according to claim 1, **characterized in that**, the film structure (FS) comprises a flap pair (FP), the flap pair (FP) comprises a first flap (FL1) and a second flap (FL2), and the semiconductor device (SD1 or SD2) comprises:
a first protruding structure (PS1) disposed adjacent to a first free edge (FE1) of the first flap (FL1) and configured to enhance a thickness of the first free edge (FE1) in the cross sectional view; and
a second protruding structure (PS2) disposed adjacent to a second free edge (FE2) of the second flap (FL2) and configured to enhance a thickness of the second free edge (FE2) in the cross sectional view.

3. The semiconductor device (SD1 or SD2) according to claim 2, **characterized in that**,
the first protruding structure (PS1) and the second protruding structure (PS2) are disposed on the same side of the film structure (FS); or
the first protruding structure (PS1) and the second protruding structure (PS2) are disposed above the film structure (FS); or
the first protruding structure (PS1) and the second protruding structure (PS2) are disposed under the film structure (FS).

4. The semiconductor device (SD1 or SD2) according to any one of claims 2 to 3, **characterized in that**, the flap pair (FP) possesses an initial deflection difference or exhibits an average displacement difference between the first flap (FL1) and the second flap (FL2).

5. The semiconductor device (SD1 or SD2) according to any one of claims 2 to 4, **characterized in that**,
the flap pair (FP) performs a differential mode movement, to form a virtual valve (VV) at a valve opening frequency; or
the first flap (FL1) is actuated to be bent toward a first direction while the second flap (FL2) is actuated to be bent toward a second direction opposite to the first direction.

6. The semiconductor device (SD1 or SD2) according to claim 5, **characterized in that**,
the flap pair (FP) performs a common mode movement, to form an air pressure variation; or
the flap pair (FP) performs a common mode movement, and a pressure variant frequency corresponding to the common mode movement and the valve opening frequency corresponding to the differential mode movement are the same.

7. The semiconductor device (SD1 or SD2) according to any one of claims 5 to 6, **characterized in that**, the virtual valve (VV) is closed when the first flap (FL1) is at a first reversal point and the second flap (FL2) is at a second reversal point.

8. The semiconductor device (SD1, SD2 or SD1_1) according to any one of claims 1 to 7,
**characterized in that**, the film structure (FS) comprises a flap pair (FP), the flap pair (FP) comprises a first flap (FL1) and a second flap (FL2);
wherein the first flap (FL1) is driven by a first valve driving signal and the second flap (FL2) is driven by a second valve driving signal, to form a virtual valve (VV);
wherein the first valve driving signal comprises a first bias voltage, the second valve driving signal comprises a second bias voltage, and the first bias voltage is different from the second bias voltage.

9. The semiconductor device (SD1, SD2 or SD1_1) according to claim 8, **characterized in that**, the first valve driving signal has a first polarity with respect to the first bias voltage, the second valve driving signal has a second polarity with respect to the second bias voltage, and the first polarity and the second polarity are opposite to each other.

10. The semiconductor device (SD1, SD2 or SD1_1) according to any one of claims 8 to 9, **characterized in that**, the first flap (FL1) and the second flap (FL2) are driven by a pressure driving signal, to perform a common mode movement to form an air pressure variation.

11. The semiconductor device (SD1, SD2, SD1_1 or SD1_2) according to any one of claims 1 to 10, **characterized in that**, the film structure (FS) is actuated to form a virtual valve (VV) in a time segment, and an airflow passes through the virtual valve (VV) during the time segment.

12. A manufacturing method of a semiconductor device (SD1, SD2, SD1_1 or SD1_2), **characterized by,** comprising:
providing a wafer (WF);
forming a slit (SL) on the wafer (WF), wherein the slit (SL) defines a free edge (FE) of a film structure (FS); and
forming a protruding structure (PS) on the free edge (FE) of the film structure (FS), wherein the protruding structure (PS) is configured to enhance a thickness of the free edge (FE) in a cross sectional view.

13. The manufacturing method according to claim 12, **characterized in that**, the wafer (WF) comprises a first layer (WL1) and a second layer (WL2), and the manufacturing method comprises:
patterning the first layer (WL1) to form the slit (SL); and
patterning the second layer (WL2), such that the film structure (FS) is formed in the first layer (WL1);
wherein the film structure (FS) comprises a flap pair (FP), the flap pair (FP) comprises a first flap (FL1) and a second flap (FL2) opposite to each other, the first flap (FL1) has a first free edge (FE1), the second flap (FL2) has a second free edge (FE2), and the first free edge (FE1) is separated from the second free edge (FE2) by the slit (SL).

14. The manufacturing method according to any one of claims 12 to 13, **characterized in that**, the wafer (WF) comprises a first layer (WL1) and a second layer (WL2), and the manufacturing method comprises:
forming a first protruding structure (PS1) adjacent to a first free edge (FE1) and configured to enhance a thickness of the first free edge (FE1) in the cross sectional view; and
forming a second protruding structure (PS2) adjacent to a second free edge (FE2) and configured to enhance a thickness of the second free edge (FE2) in the cross sectional view.

15. The manufacturing method according to claim 14, **characterized in that**,
the first protruding structure (PS1) and the second protruding structure (PS2) are formed by a first forming process, and the first forming process comprises:
forming a structure layer (SSL) on the first layer (WL1); and
patterning the structure layer (SSL) to form the first protruding structure (PS1) and the second protruding structure (PS2); or
the first protruding structure (PS1) and the second protruding structure (PS2) are formed by a second forming process, and the second forming process comprises:
forming a plurality of trenches (TE) on the second layer (WL2);
forming the first layer (WL1) on the second layer (WL2) having the trenches (TE) to form the wafer (WF), wherein the first layer (WL1) is filled in the trenches (TE) to have a plurality of filled structures (FF);
patterning the first layer (WL1) to form the slit (SL) between two of the filled structures (FF); and
patterning the second layer (WL2), such that the film structure (FS) is formed in the first layer (WL1), and the first protruding structure (PS1) and the second protruding structure (PS2) are respectively formed of the two of the filled structures (FF).
